# EUROPEAN PATENT APPLICATION

(11) **EP 4 832 743 A1**
(43) Date of publication of application: **28.10.2026**
(21) Application number: 26171619.5
(22) Date of filing: 10.04.2026
(51) Int. Cl.: H10W 90/00, G11C 5/04, H10W 70/60, H10W 90/10

(54) **SEMICONDUCTOR PACKAGE USING COMBINATION OF DIFFERENT PACKAGING TECHNOLOGIES FOR INTERCONNECTIONS BETWEEN DIFFERENT DIES**

(30) Priority: 14.04.2025 US 202563788184 P; 06.04.2026 US 202619640390
(71) Applicant: MediaTek Inc., Hsinchu City 30078 (TW)
(72) Inventor: Kolluru, Krishna Bharath, San Jose, CA 95134 (US); Kumar, Arvind, San Jose, CA 95134 (US); Nalamalpu, Ankireddy, San Jose, CA 95134 (US); Kumashikar, Mahesh K., San Jose, CA 95134 (US); Subbareddy, Dheeraj Reddy, San Jose, CA 95134 (US); Gadey, Siva, San Jose, CA 95134 (US)
(74) Representative: Pfenning, Meinig & Partner mbB

(57) **Abstract**

A semiconductor package (100) includes a package substrate (102), an interposer (104), at least one first component (106_1, 106_N), and a plurality of second components (108_1, 108_M). The package substrate (102) includes at least one first embedded interconnect (110_1, 110_K) of a first packaging technology. The interposer (104) is mounted on the package substrate (102), and includes at least one second embedded interconnect (112_J) of a second packaging technology. The at least one first component (106_1, 106_N) is mounted on the package substrate (102), and electrically connected to the interposer (104) through the at least one first embedded interconnect (110_1, 110_K) of the package substrate (102). The second components (108_1, 108_M) are mounted on the interposer (104), and two of the second components (108_1, 108_M) are electrically connected through one of the at least one second embedded interconnect (112_J) of the interposer (104).

## Description

### Field of the Invention

The present disclosure relates to an integrated circuit (IC) design, and more particularly, to a semiconductor package using a combination of different packaging technologies for die complex expansion.

### Background of the Invention

Advanced packaging refers to a set of semiconductor integration technologies that go beyond traditional wire bonding and flip chip packages, enabling higher bandwidth, lower power, smaller form factor, and heterogeneous integration of multiple dies. However, as the die complex expands, the single-vendor advanced packaging solution faces physical reticle limits and cost constraints. Thus, there is a need for an innovative semiconductor package design which leverages advantages of different advanced packaging technologies to expand the die complex size beyond what is possible on a conventional semiconductor package using a single advanced packaging technology.

### Summary of the Invention

This in mind, the present invention aims at providing a semiconductor package using a combination of different packaging technologies for die complex expansion.

This is achieved by a semiconductor package according to the independent claim. The dependent claims pertain to corresponding further developments and improvements. The scope of the invention is defined by the appended sets of claims.

As will be seen more clearly from the detailed description following below, the claimed semiconductor package includes a package substrate, an interposer, at least one first component, and a plurality of second components. The package substrate includes at least one first embedded interconnect of a first packaging technology. The interposer is mounted on the package substrate, and includes at least one second embedded interconnect of a second packaging technology. The at least one first component is mounted on the package substrate, and electrically connected to the interposer through the at least one first embedded interconnect of the package substrate. The second components are mounted on the interposer, and two of the second components are electrically connected through one of the at least one second embedded interconnect of the interposer.

### Brief Description of the Drawings

In the following, the invention is further illustrated by way of example, taking reference to the accompanying drawings. Thereof
FIG. 1 is a diagram illustrating a structure of a semiconductor package according to an embodiment of the present invention,
FIG. 2 is a top view of a semiconductor package with a maximized compute area according to an embodiment of the present invention,
FIG. 3 is a cross-section view along line A-A' of the semiconductor package shown in FIG. 2,
FIG. 4 is a top view of a semiconductor package with EW-direction memory stacking according to an embodiment of the present invention, and
FIG. 5 is a cross-section view along line B-B' of the semiconductor package shown in FIG. 4.

### Detailed Description

Certain terms are used throughout the following description and claims, which refer to particular components. As one skilled in the art will appreciate, electronic equipment manufacturers may refer to a component by different names. This document does not intend to distinguish between components that differ in name but not in function. In the following description and in the claims, the terms "include" and "comprise" are used in an open-ended fashion, and thus should be interpreted to mean "include, but not limited to ...". Also, the term "couple" is intended to mean either an indirect or direct electrical connection. Accordingly, if one device is coupled to another device, that connection may be through a direct electrical connection, or through an indirect electrical connection via other devices and connections.

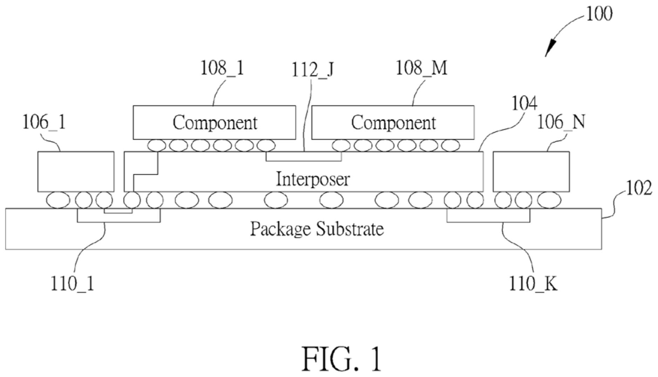

FIG. 1 is a diagram illustrating a structure of a semiconductor package according to an embodiment of the present invention. The semiconductor package 100 includes a package substrate (e.g., organic substrate) 102, an interposer 104, at least one first components 106_1-106_N (N ≥ 1), and a plurality of second components 108_1-108_M (M ≥ 2). The package substrate 102 includes at least one first embedded interconnect 110_1-110_K (K ≥ 1) of a first packaging technology. The interposer 104 is mounted on the package substrate 102, and includes at least one second embedded interconnect 112_J (J ≥ 1) of a second packaging technology. The at least one first component 106_1-106_N (N ≥ 1) is mounted on the package substrate 102, and electrically connected to the interposer 104 through the at least one first embedded interconnect 110_1-110_K (K ≥ 1) of the package substrate 102. The second components 108_1-108_M (M ≥ 2) are mounted on the interposer 104, and two of the second components 108_1-108_M (M ≥ 2) are electrically connected through one of the at least one second embedded interconnect 112_J (J ≥ 1) of the interposer 104.

In some embodiments of the present invention, the first packaging technology may be Coupled Embedded Multi-die Interconnect Bridge (Co-EMIB), and each first embedded interconnect 110_K (K ≥ 1) may be a silicon bridge (i.e., EMIB bridge) buried in the package substrate 102. In some embodiments of the present invention, the second packaging technology may be Chip-on-Wafer-on-Substrate with Local Silicon Interconnect (CoWoS-L), and each second embedded interconnect 112_J (J ≥ 1) may be a local silicon interconnect (LSI) embedded in a redistribution layer (RDL) based interposer. For better comprehension of technical features of the present invention, the following assumes that the semiconductor package 100 uses a combination of CoWoS-L and Co-EMIB for die complex expansion. For example, with the aid of Co-EMIB, first components 106_1-106_N can be placed on the package substrate 102 to expand the die complex to 8x.

Components assembled and encapsulated in the semiconductor package 100 may include chiplets and memory chips. In practice, the present invention has no limitations on placement of components on the interposer 104 and components on the package substrate 102. In other words, any semiconductor package using a combination of different packaging technologies (e.g., CoWoS-L and Co-EMIB) for die complex expansion falls within the scope of the present invention.

A high bandwidth memory (HBM) adopts a three-dimensional (3D) stacking approach by vertically stacking multiple HBM dynamic random access memory (DRAM) dies on a logic die (also called base die), and uses through-silicon via (TSV) stacks to electrically connect the HBM DRAM dies to the logic die. An HBM may be mounted on the package substrate 102 or the interposer 104, depending upon actual design considerations.

A compute die may be a graphics processing unit (GPU) die, a central processing unit (CPU) die, a system-on-a-chip (SoC) die, or any datacenter processor die. A computer die may be mounted on the package substrate 102 or the interposer 104, depending upon actual design considerations.

In some embodiments of the present invention, the at least one first component 106_1-106_N (N ≥ 1) mounted on the package substrate 102 may include one or more HBMs. In some embodiments of the present invention, the at least one first component 106_1-106_N (N ≥ 1) mounted on the package substrate 102 may include one or more compute dies. In some embodiments of the present invention, the at least one first component 106_1-106_N (N ≥ 1) mounted on the package substrate 102 may include one or more high bandwidth memories (HBMs) and one or more compute dies.

In some embodiments of the present invention, the second components 108_1-108_M (M ≥ 2) mounted on the interposer 104 may include one or more compute dies. In some embodiments of the present invention, the second components 108_1-108_M (M ≥ 2) mounted on the interposer 104 may include one or more HBMs. In some embodiments of the present invention, the second components 108_1-108_M (M ≥ 2) mounted on the interposer 104 may include one or more compute dies and one or more HBMs.

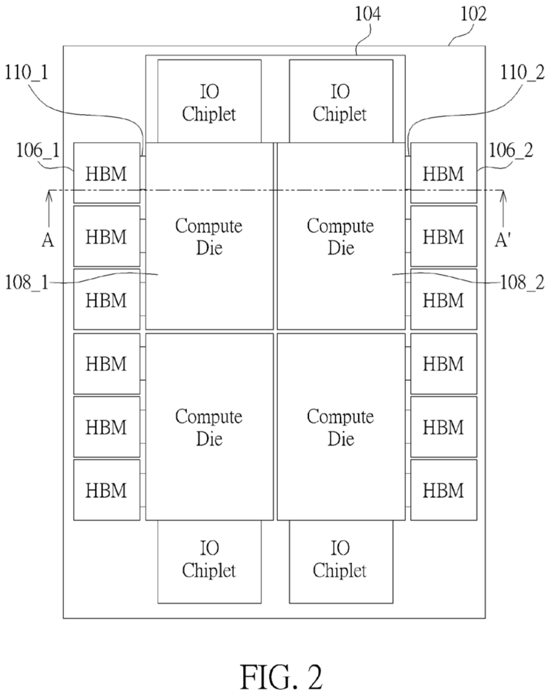

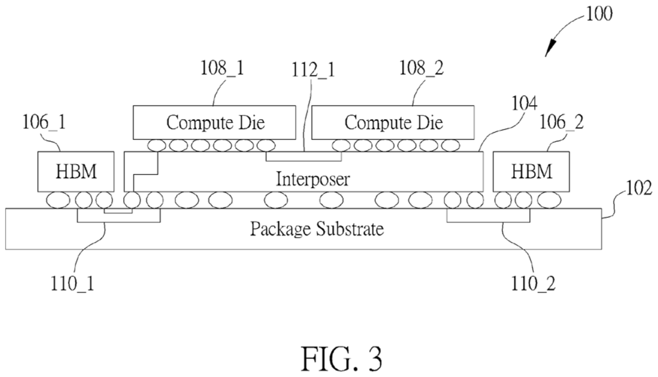

In most cases, the interposer 104 is more expensive than the package substrate 102. In some embodiments of the present invention, the second components 108_1-108_M (M ≥ 2) mounted on the interposer 104 may include all compute dies assembled and encapsulated in the semiconductor die 100, and the interposer 104 has no HBMs mounted thereon. This enables the interposer 104 to be utilized completely for compute, thereby maximizing the compute area. FIG. 2 is a top view of a semiconductor package with a maximized compute area according to an embodiment of the present invention. FIG. 3 is a cross-section view along line A-A' of the semiconductor package shown in FIG. 2. In this embodiment, the first components 106_1 and 106_2 included in the semiconductor package 100 are HBMs, and the second components 108_1 and 108_2 included in the semiconductor package 100 are compute dies. The second components (i.e., compute dies) 108_1 and 108_2 are electrically connected though one second embedded interconnect (e.g., CoWoS-L LSI) 112_1. The first component (i.e., HBM) 106_1 is electrically connected to the interposer 104 through one first embedded interconnect (e.g., EMIB bridge) 110_1. The first component (i.e., HBM) 106_2 is electrically connected to the interposer 104 through another first embedded interconnect (e.g., EMIB bridge) 110_2. As shown in FIG. 2, all HBMs are mounted on the package substrate 102. In this way, four compute-intensive compute dies can be mounted on the interposer 104.

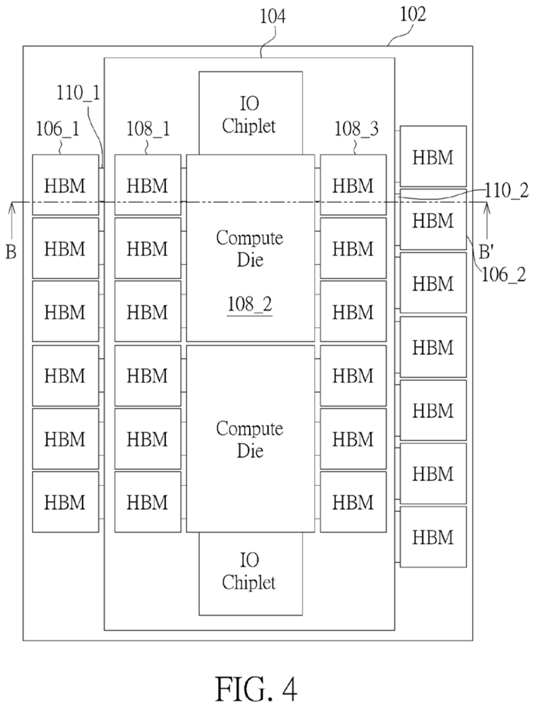

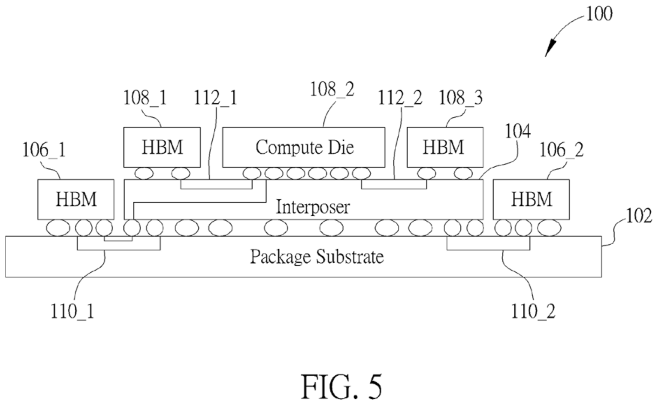

In some embodiments of the present invention, the combination of different packaging technologies (e.g., CoWoS-L and Co-EMIB) also provides the ability to stack memory chips in the same direction (e.g., east-west (EW) direction). FIG. 4 is a top view of a semiconductor package with EW-direction memory stacking according to an embodiment of the present invention. FIG. 5 is a cross-section view along line B-B' of the semiconductor package shown in FIG. 4. In this embodiment, the first components 106_1, 106_2 and the second components 108_1, 108_3 included in the semiconductor package 100 are HBMs, and the second component 108_2 included in the semiconductor package 100 is a compute die. The second components (i.e., HBM and compute die) 108_1 and 108_2 are electrically connected though one second embedded interconnect (e.g., CoWoS-L LSI) 112_1, and the second components (i.e., compute die and HBM) 108_2 and 108_3 are electrically connected though another second embedded interconnect (e.g., CoWoS-L LSI) 112_2. The first component (i.e., HBM) 106_1 is electrically connected to the interposer 104 through one first embedded interconnect (e.g., EMIB bridge) 110_1. The first component (i.e., HBM) 106_2 is electrically connected to the interposer 104 through another first embedded interconnect (e.g., EMIB bridge) 110_2.

As shown in FIG. 5, the first component (i.e., HBM) 106_1 and the second component (i.e., HBM) 108_1 are offset in a vertical direction and arranged side-by-side in a horizontal direction, and the first component (i.e., HBM) 106_2 and the second component (i.e., HBM) 108_3 are offset in a vertical direction and arranged side-by-side in a horizontal direction. As shown in FIG. 4, the first component (i.e., HBM) 106_1 and the second component (i.e., HBM) 108_1 on one side of the compute die 108_2 are stacked in an EW direction of the semiconductor package 100 (particularly, the EW direction of the top view of the semiconductor package 100) and arranged in HBM behind HBM stacking without an offset in a north-south (NS) direction of the semiconductor package 100 (particularly, the NS direction of the top view of the semiconductor package 100), while the first component (i.e., HBM) 106_2 and the second component (i.e., HBM) 108_3 on another side of the compute die 108_2 are stacked in the EW direction of the semiconductor package 100 (particularly, the EW direction of the top view of the semiconductor package 100) and arranged in HBM behind HBM stacking with an offset in the NS direction of the semiconductor package 100 (particularly, the NS direction of the top view of the semiconductor package 100). The arrangement of HBM behind HBM stacking with offset can reduce signal routing challenges in the interposer 104. However, this is for illustrative purposes only, and is not meant to be a limitation of the present invention.

## Claims

1. A semiconductor package (100) **characterized by**:
a package substrate (102), comprising:
at least one first embedded interconnect (110_1, 110_K) of a first packaging technology;
an interposer (104), mounted on the package substrate (102), wherein the interposer (104) comprises:
at least one second embedded interconnect (112_J) of a second packaging technology;
at least one first component (106_1, 106_N), mounted on the package substrate (102), wherein the at least one first component (106_1, 106_N) and the interposer (104) are electrically connected through the at least one first embedded interconnect (110_1, 110_K) of the package substrate (102); and
a plurality of second components (108_1, 108_M), mounted on the interposer (104), wherein two of the plurality of second components (108_1, 108_M) are electrically connected through one of the at least one second embedded interconnect (112_J) of the interposer (104).

2. The semiconductor package (100) of claim 1, **characterized in that** the first packaging technology is Coupled Embedded Multi-die Interconnect Bridge.

3. The semiconductor package (100) of claim 2, **characterized in that** the second packaging technology is Chip-on-Wafer-on-Substrate with Local Silicon Interconnect.

4. The semiconductor package (100) of claim 1, **characterized in that** the second packaging technology is Chip-on-Wafer-on-Substrate with Local Silicon Interconnect.

5. The semiconductor package (100) of claim 1, **characterized in that** the at least one first component (106_1, 106_N) comprises at least one high bandwidth memory.

6. The semiconductor package (100) of claim 5, **characterized in that** the at least one first component (106_1, 106_N) further comprises at least one compute die.

7. The semiconductor package (100) of claim 1, **characterized in that** the at least one first component (106_1, 106_N) comprises at least one compute die.

8. The semiconductor package (100) of claim 1, **characterized in that** the plurality of second components (108_1, 108_M) comprise at least one compute die.

9. The semiconductor package (100) of claim 8, **characterized in that** the plurality of second components (108_1, 108_M) further comprise at least one high bandwidth memory.

10. The semiconductor package (100) of claim 1, **characterized in that** the plurality of second components (108_1, 108_M) comprise at least one high bandwidth memory.

11. The semiconductor package (100) of claim 1, **characterized in that** the plurality of second components (108_1, 108_M) comprise a plurality of compute dies, and the interposer (104) has no high bandwidth memories mounted thereon.

12. The semiconductor package (100) of claim 1, **characterized in that** the at least one first component (106_1, 106_N) comprises a first high bandwidth memory, HBM, the plurality of second components (108_1, 108_M) comprise a second HBM, and the first HBM and the second HBM are stacked in an east-west direction of the semiconductor package (100) and arranged in HBM behind HBM stacking without an offset in a north-south direction of the semiconductor package (100).

13. The semiconductor package (100) of claim 1, **characterized in that** the at least one first component (106_1, 106_N) comprises a first high bandwidth memory, HBM, the plurality of second components (108_1, 108_M) comprise a second HBM, and the first HBM and the second HBM are stacked in an east-west direction of the semiconductor package (100) and arranged in HBM behind HBM stacking with an offset in a north-south direction of the semiconductor package (100).
